Europäisches Patentamt

European Patent Office

Office européen des brevets

(19)

(11) Publication number: **0 482 907 A2**

## (12) EUROPEAN PATENT APPLICATION

(21) Application number: 91309788.7

(22) Date of filing: 23.10.91

(51) Int. Cl.$^5$: **H01J 37/32, H01L 21/00**

(30) Priority: **24.10.90 JP 284403/90**

(43) Date of publication of application:
**29.04.92 Bulletin 92/18**

(84) Designated Contracting States:
**DE FR GB**

(71) Applicant: **FUJITSU LIMITED**
**1015, Kamikodanaka Nakahara-ku**
**Kawasaki-shi Kanagawa 211 (JP)**

(71) Applicant: **FUJITSU YAMANASHI**
**ELECTRONICS LIMITED**
**1000, Kamisukiahara, Showa-cho**
**Nakakoma-gun, Yamanashi, 409-38 (JP)**

(72) Inventor: **Mochizuki, Fujio, c/o Fujitsu**
**Yamanashi Elec.Ltd.**
**1000, Kamisukiahara, Showamachi**
**Nakakoma-gun, Yamanashi 409-38 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

(54) Electrode structures.

(57)  An etching apparatus for producing a semi-conductor device using a wafer formed of a semi-insulating or insulating substance comprises an electrode (14) and a wafer lifter (18) moveable up and down relative to the electrode (14). A table portion (18a) of the wafer lifter is accommodated in a recess (16) formed in the top surface of the electrode (14) when the wafer lifter (14) is displaced to a lowermost position thereof, so that the top surface of the table portion (18a) is flush with the top surface of the electrode (14). Profiles of an outer side wall (A) of the table portion (18a) and an inner side wall (B) of the recess (16) of the electrode (14) have an identical conical-shaped surface and are brought in contact with each other when the wafer lifter (18) is displaced to the lowermost position thereof at which the top surface of the wafer lifter (18) is flush with the top surface of the electrode (14).

*Fig. 3 (b)*

The present invention relates to electrode structures for use, for example, in plasma etching apparatus to support wafers, employed in the production of semiconductor devices, in an electric field generated within the apparatus.

In a plasma etching apparatus, a wafer is placed on or removed from an electrode of the apparatus by a manipulator, and to enable the wafer to be held by the manipulator, the wafer must be lifted away from the top surface of the electrode.

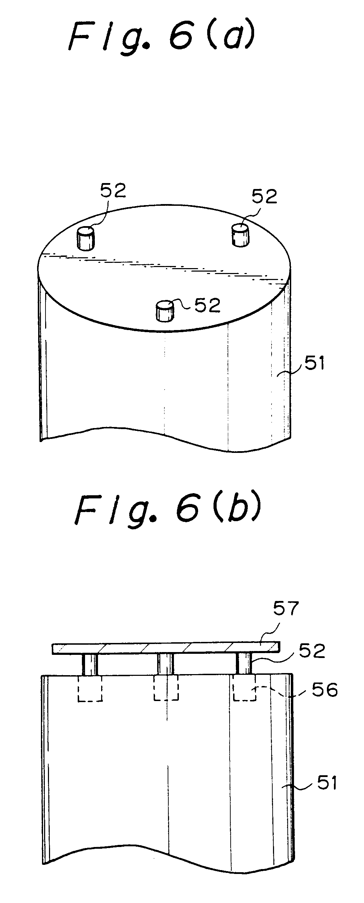

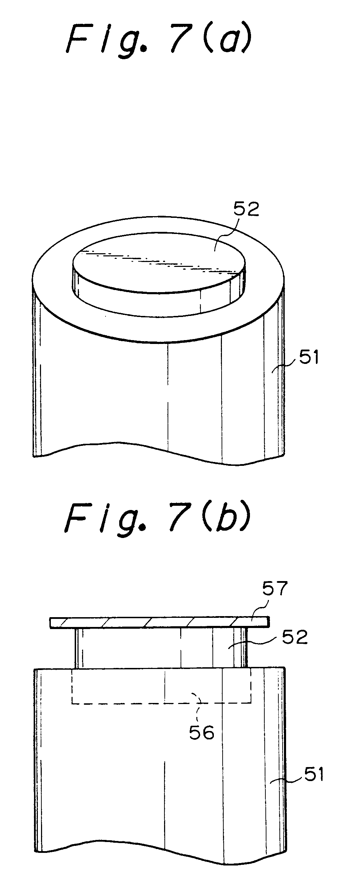

A previously-considered electrode of a plasma etching apparatus, denoted at 51 in Figs. 6(a) and 6(b), is provided with a plurality of cylindrical wafer lifters 52 moveable up and down in respective recesses 56 formed in the flat top surface of the electrode 51. A wafer 57 is movably supported on the wafer lifters 52. Alternatively, as shown in Figs. 7(a) and 7(b), another previously-considered electrode 51 has a single lifter 52 having a flat top surface with a size slightly less, or possibly even larger than that of a wafer 57 to be placed thereon, which is moved up and down in a recess 56 in the flat top surface of the electrode 51.

Before starting an etching operation, the wafer lifter 52 is raised so that the top surface thereof is above the top surface of the electrode 51, and the wafer 57 is then placed on the lifter 52 so that a top layer thereof to be etched faces upward, and the lifter 52 is lowered until the top surface thereof is flush with the top surface of the electrode 51, whereby the preparation for the etching of the wafer is completed.

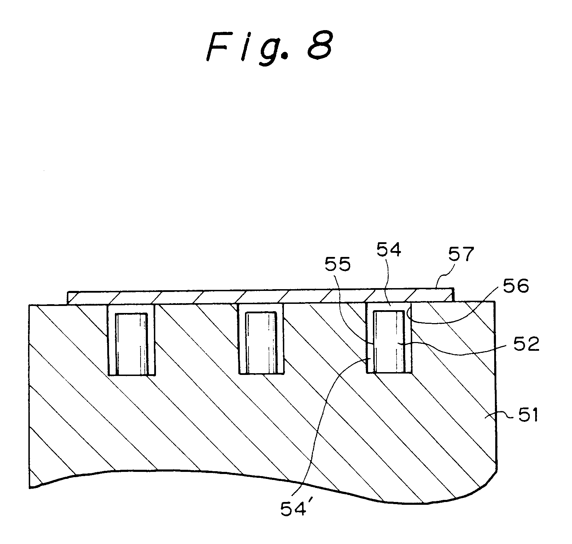

Nevertheless, it is very difficult, for structural reasons, to position the wafer lifter 52 in such a manner that the top surface thereof is flush with that of the electrode 51, and accordingly, as shown in Fig.8, a gap 54 can often be formed between the top surface of the wafer lifter 52 and the bottom surface of the wafer 57. Further, another gap 54' is naturally formed between the inner wall of the recess 56 and the outer wall of a sliding portion 55 of the wafer lifter 52, and as a result, the wafer 57 is not brought in contact with the electrode 51 in the area wherein the gaps 54, 54' are formed.

Even though non-contact areas exist between the wafer 57 and the electrode 51, a potential distribution in the wafer surface is uniform and a uniform etching of the wafer can be carried out when the wafer is formed of a semi-conductive substance having a high electro-conductivity such as Si. If, however, the wafer is formed of a semi-insulating or insulating substance such as Ga-As or In-P, the potential distribution can become nonuniform, due to the above-mentioned gaps, and thus the etched depth of the wafer surface is liable to be irregular.

It is desirable to provide a plasma etching apparatus having an electrode provided with wafer lifters, in which a wafer placed thereon can be substantially uniformly etched over the entire surface thereof, even though the wafer is formed of a semi-conductive or insulating substance.

An embodiment of a first aspect of the present invention can provide an etching aparratus, for producing a semiconductor device, comprising a lower electrode having a flat top surface on which a wafer to be etched is placed and at least a wafer lifter, and an upper electrode mating with the lower electrode for generating an electric field therebetween, said wafer lifter being movable up and down through the lower electrode by a drive means and accommodated in a recess formed in the top surface of the lower electrode when the wafer lifter is displaced to a lowermost position thereof. The apparatus is characterized in that the said wafer lifter has an upper table portion with a flat top surface and a tapered outer side wall diverging upward, and an inner side wall of the recess of the lower electrode has an identical shape with that of the outer side wall of the table portion; whereby the side walls of the recess and the table portion are brought into contact with each other and the top surface of the table portion of the wafer lifter is flush with the top surface of the lower electrode when the wafer lifter is displaced to the lowermost position thereof.

Further, only one wafer lifter may be provided at a center of the electrode, but alternatively, a plurality of wafer lifters may be circularly arranged on the top surface of the electrode in positions corresponding to the respective apertures and recesses.

The profiles of an outer side wall of the table portion of the wafer lifter and an inner side wall of the recess of the electrode may have a conical surface.

An embodiment of a second aspect of the present invention can provide an etching apparatus for producing a semiconductor device, comprising a lower electrode having a flat top surface on which a wafer to be etched is placed and at least a wafer lifter, and an upper electrode mating with the lower electrode for generating an electric field therebetween, said wafer lifter being movable up and down along the outer side wall of the lower electrode by a drive means; characterized in that said wafer lifter is in a tubular form having an upper table portion with an annular flat top surface and a tapered inner side wall converging upward, and an outer side wall of an upper portion of the lower electrode has an identical shape with that of the inner side wall of the table portion;

whereby the side walls of the lower electrode and the table portion are brought into contact with each other and the top surface of the table portion of the wafer lifter is flush with the top surface of the lower electrode when the wafer lifter is displaced to the lowermost position thereof.

In an embodiment of the present invention, the wafer lifter and the electrode, respectively, have outer/inner side walls each having a corresponding and identical conical shape at the upper end portion thereof, and defined such that when the wafer lifter is displaced to the lowermost position thereof, both of the side walls are brought into contact with each other. Therefore, the top surfaces of the wafer lifter and the electrode are naturally positioned to be flush with each other at the lowermost position of the wafer lifter, and further, no lateral gap exists between the wafer lifter and the electrode on the top surfaces at that position. Accordingly, a uniform etching operation can be carried out on a wafer placed on the electrode and wafer lifter, even though the wafer is made of an insulating or semi-insulating substance.

Reference will now be made, by way of example, to the accompanying drawings, in which:

Figure 1 is a schematic general view of a plasma etching apparatus;

Figure 2 is a diagrammatic side sectional view of parts of a plasma etching apparatus embodying the present invention;

Figure 3(a) is a perspective view of a combination of wafer lifter and electrode included in plasma etching apparatus according to a first embodiment of the present invention;

Figure 3(b) is a side view corresponding to Fig. 3(a);

Figure 4(a) is a perspective view of a combination of wafer lifter and electrode included in plasma etching apparatus according to a second embodiment of the present invention;

Figure 4(b) is a side view corresponding to Fig. 4(a);

Figure 5(a) is a perspective view of a combination of wafer lifter and electrode included in plasma etching apparatus according to a third embodiment of the present invention;

Figure 5(b) is a side view corresponding to Fig. 5(a);

Figure 6(a) is a perspective view of a previously-considered combination of wafer lifter and electrode;

Figure 6(b) is a side view corresponding to Fig. 6(a);

Figure 7(a) is a perspective view of another previously-considered combination of wafer lifter and electrode;

Figure 7 (b) is a side view corresponding to Fig. 7(a); and

Figure 8 is a longitudinal sectional view, to a larger scale, of parts of the combination of Fig. 6(b).

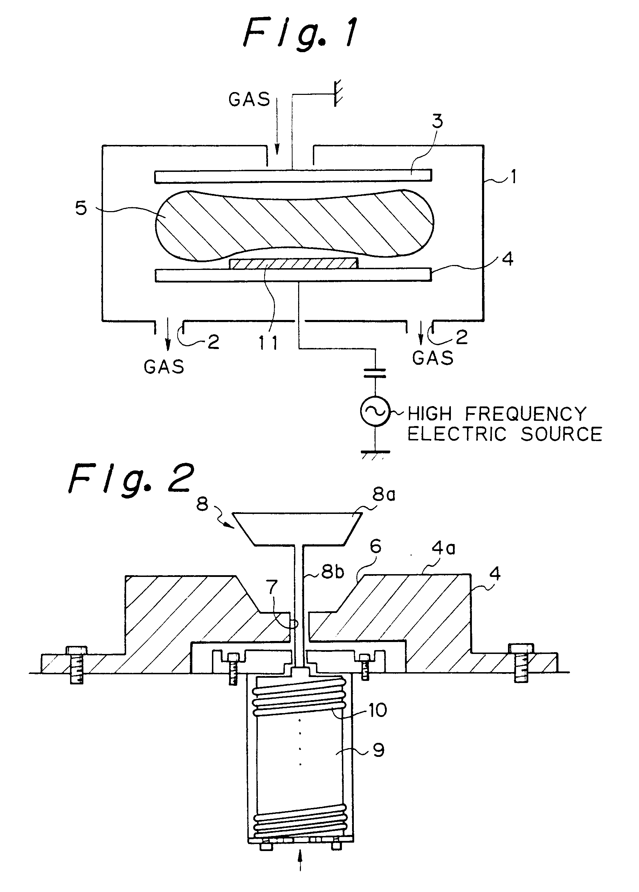

Figure 1 shows a general structure of a plasma etching apparatus. In a vacuum chamber 1 from which an interior atmosphere is always discharged through an exit port 2, an upper electrode 3 and a lower electrode 4 are arranged so that they confront one another. A high voltage is applied to the lower electrode 4 and the upper electrode 3 is earthed. A reacting gas is introduced into the chamber 1 and converted to plasma 5 between the electrodes 3, 4, which plasma etches an exposed (upper) surface of a wafer 11 placed on the lower electrode 4.

Figure 2 illustrates a structure of the lower electrode 4 having a flat top surface 4a on which a wafer is placed. A recess 6 is formed at a central area of the electrode 4, and a vertical aperture 7 extends through the electrode 4. A wafer lifter 8 is provided and comprises an upper table portion 8a and a lower stem portion 8b. The stem portion 8b is inserted into the aperture 7 and the table portion 8a fits in the recess 6. Movement of the wafer lifter 8 up and down is brought about by bellows 9 and a spring 10.

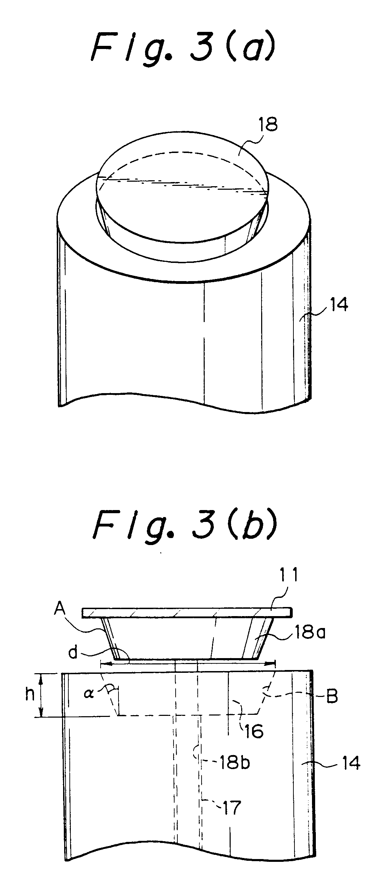

As shown in Figs. 3(a) and 3(b), according to a first embodiment of the present invention, a single wafer lifter 18 is provided for a lower electrode 14 having a flat top surface. The wafer lifter 18 has an upper table portion 18a with a conical outer side wall A diverging upward, and a top surface of the table portion 18a is flat and has a diameter smaller than that of a wafer 11 to be held thereon, so that the wafer 11 can be placed on or removed from an electrode by a manipulator (not shown).

A lower electrode 14 has a recess 16 in a center area of a top surface thereof with an inner side wall B diverging upward; the recess 16 has a profile and size, i.e., a height h, a diameter d and a taper angle $\alpha$, identical to those of the table portion 18a of the wafer lifter 18 and is moveable up and down by sliding a stem portion 18b along an aperture 17 formed through the electrode 14.

Before starting an etching operation, the wafer 11 is placed on the top surface of the wafer lifter 18 lifted above the top surface of the lower electrode 14, and the wafer lifter 18 is then lowered to the lowermost position thereof. As the profile and size of the side walls A and B are identical, the top surfaces of the wafer lifter 18 and the electrode 14 are flush with each other when the wafer lifter 18 reaches the lowermost position and the side walls A and B are brought into contact therewith. Accordingly, no gaps are formed between the bottom surface of the wafer 11 and the top surface of the wafer lifter 16, or between the side walls A of the table portion 18a and the side wall B of the recess 16, whereby an effective an uniform etching can be carried out over the whole surface of the wafer.

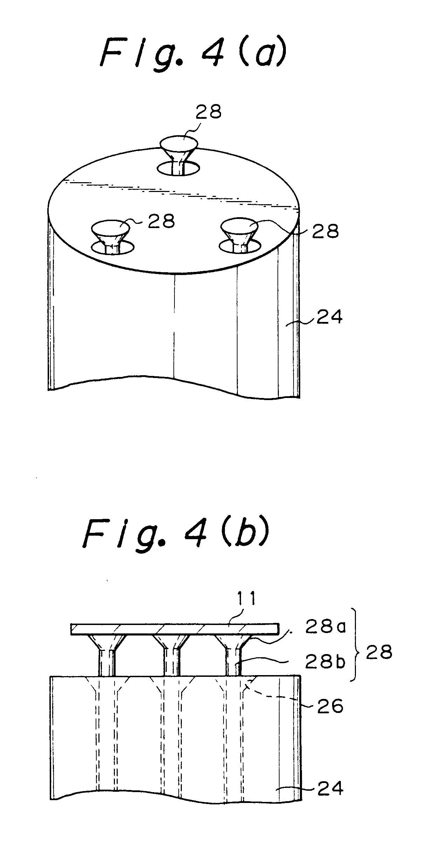

As shown in Figs. 4(a) and 4(b), according to a second embodiment of the present invention, a plurality of (three in the illustrated embodiment) wafer lifters 28 are circularly arranged on a top surface of a lower electrode 24. All the wafer lifters 28 can be simultaneously moved up and down by a mechanism similar to that described before. Each wafer lifter 28 has a table portion 28a, (as in the first embodiment) which is complementary in shape to an associated recess 26. Accordingly, when all of the wafer lifters 28 are lowered in synchronization with each other to the lowermost position thereof, while carrying the wafer 11 thereon, the wafer 11 is located on the top surface of the electrode 24 flush with the top surface of the wafer lifter 28.

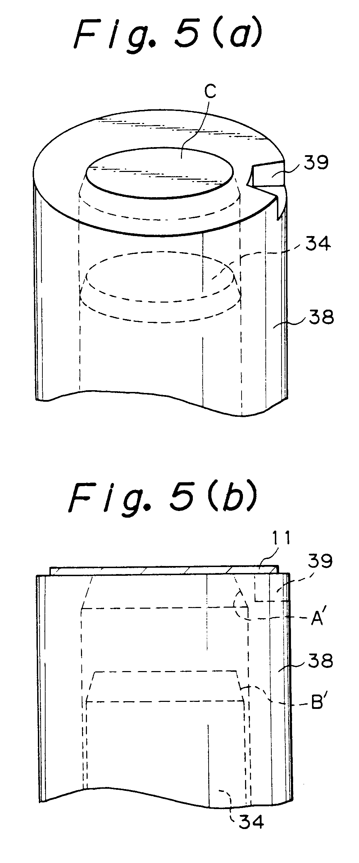

As shown in Figs. 5(a) and 5(b), according to a third embodiment of the present invention, a tubular form wafer lifter 38 is fitted around a central lower electrode 34 so that-the former is moveable up and down by sliding an inner side wall of the wafer lifter 38 along the outer side wall of the latter.

A top surface of the wafer lifter 38 is flat and the upper portion of the inner side wall A′ of the wafer lifter 38 has a conical shape converging upward so that an opening C has a diameter smaller than that of a wafer 11 placed thereon. A notch 39 is formed on the periphery of the top surface of the wafer lifter 38, to allow the introduction of a manipulator (not shown) beneath the wafer 11.

The electrode 34 also has a top portion having an outer side wall B′ in a conical shape converging upward; the profiles and sizes of both conical side walls being identical.

As in the preceding embodiments, when the wafer lifter 38 is lowered to the lowermost position thereof, the conical side walls A′ and B′ are brought into contact with each other and the top surfaces of the electrode 34 and the wafer lifter 38 become flush with each other, in the same manner as in the preceding embodiments.

As described above, in a plasma etching apparatus embodying the invention, a wafer lifter is constituted such that the top surfaces of the wafer lifter and the electrode are substantially flush with one another when the conical side wall of the wafer lifter is brought into contact with the mating conical side wall of the electrode. Therefore, the lowermost position of the wafer lifter can be easily defined by mechanically and/or electrically utilizing this contact (wedging action) of the side walls. As a result of the uniformity in level of the top surfaces of the electrode and wafer lifter, without gaps therebetween, a potential distribution on the wafer to be etched becomes uniform, and thus an effective uniform etching operation can be carried out over the whole surface of the wafer.

A comparative test was conducted of an apparatus embodying the present invention and a previously-considered apparatus, by etching a positive type photoresist layer formed on a Ga-As wafer while using the plasma etching apparatus of Figs. 3(a) and 3(b), in which the power applied to a lower electrode was 2.0 kw, the interior pressure of a chamber was 2.5 m Torr, the reacting gas was oxygen, fed at a rate of 25 SCCM, and the operation time was 30 sec.

A depth E of a trench formed on the wafer surface by the etching operation was measured at five uniformly distributed predetermined points on the wafer surface, and the results were evaluated by an index U obtained from the following formula:

$$U = [(E_{max} - E_{min})/(E_{max} + E_{min})] \times 100$$

wherein $E_{max}$ is the maximum of the five E values obtained, and $E_{min}$ is the minimum thereof.

For the apparatus of Figs. 3(a) and 3(b), U was 2.5%, but in the previously-considered apparatus illustrated in Figs. 7(a) and 7(b), U was more than 10%. This tendency was maintained even when the test conditions changed.

Embodiments of the present invention can be particularly effective in the case of wafers having an electro-resistance of more than $10^7 \Omega \cdot cm$.

Thus, an embodiment of the present invention can provide plasma etching apparatus including an improved combination of a lower electrode and a wafer lifter, in which, when a wafer is placed on the top surface of the lower electrode, no significant gaps are formed between the electrode, the wafer lifter and the wafer.

## Claims

1. An electrode structure for supporting a wafer (11), during a device manufacturing process, in an electric field established between the electrode structure (4) and an opposing electrode (3), which structure comprises a first component (14), having a first flat working face, and a second component (18) that is moveable with respect to the first component (14) and has a second flat working face which, when the second component (18) is in a first position thereof relative to the first component (14), is substantially co-planar with the said first working face so that the two working faces can support such a wafer (11) jointly, the said second component (18) being moveable, relative to the first component (14), to a second position in which the said second working face is displaced from the first working face in a direction perpendicular thereto;

   characterised in that the said first and second components have respective lateral surface portions (B, A) which are complementary in form to one another and extend obliquely in relation to the said direction, so that as the second component (18) is moved from the said second position to the first position a wedging action between those lateral surface portions (B, A) causes the said second working face to be brought into close peripheral proximity to the said first working face such that the two working faces together provide a substantially continuous support surface.

2. A plasma etching apparatus for producing a semiconductor device, comprising a lower electrode having a flat top surface on which a wafer to be etched is placed and at least a wafer lifter, and an upper electrode mating with the lower electrode for generating an electric field therebetween, said wafer lifter being movable up and down through the lower electrode by a drive means and accommodated in a recess formed in the top surface of the lower electrode when the wafer lifter is displaced to a lowermost position thereof; characterized in that said wafer lifter has an upper table portion with a flat top surface and a tapered outer side wall diverging upward, and an inner side wall of the recess of the lower electrode has an identical shape with that of the outer side wall of the table portion;

whereby the side walls of the recess and the table portion are brought into contact with each other and the top surface of the table portion of the wafer lifter is flush with the top surface of the lower electrode when the water lifter is displaced to the lowermost position thereof.

3. A plasma etching apparatus as defined by claim 2, characterized in that only one wafer lifter is provided at a center of the electrode.

4. A plasma etching apparatus as defined by claim 2, characterized in that a plurality of wafer lifters are circularly arranged on the top surface of the electrode and in correspondence with respective apertures and recesses.

5. A plasma etching apparatus as defined by any one of claims 2 through 4, characterized in that the profiles of an outer side wall of the table portion of the wafer lifter and an inner side wall of the recess of the electrode have a conical surface.

6. A plasma etching apparatus for producing a semi-conductive device, comprising a lower electrode having a flat top surface on which a wafer to be etched is placed and at least a wafer lifter, and an upper electrode mating with the lower electrode for generating an electric field therebetween, said wafer lifter being movable up and down along the outer side wall of the lower electrode by a drive means; characterized in that

said wafer lifter is in a tubular form having an upper table portion with an annular flat top surface and a tapered inner side wall converging upward, and an outer side wall of an upper portion of the lower electrode has an identical shape with that of the inner side wall of the table portion;

whereby the side walls of the lower electrode and the table portion are brought into contact with each other and the top surface of the table portion of the wafer lifter is flush with the top surface of the lower electrode when the wafer lifter is displaced to the lowermost position therof.

7. A plasma etching apparatus as claimed in any preceding claim, characterized in that the wafer is formed of a semi-insulating or insulating substance.

# *Fig. 1*

GAS

3

1

5

4

2 GAS

11

2 GAS

HIGH FREQUENCY
ELECTRIC SOURCE

# *Fig. 2*

8

8a

6

4a

4

7

8b

10

9

# $Fig.\ 3(a)$

# $Fig.\ 3(b)$

# Fig. 4 (a)

# Fig. 4 (b)

# F l g. 5 (a)

# F l g. 5 (b)

# F l g. 6 (a)

# F l g. 6 (b)

## F I g. 7 (a)

## F I g. 7 (b)

# F i g. 8